# EUROPEAN PATENT APPLICATION

(11) **EP 4 654 788 A2**
(43) Date of publication of application: **26.11.2025**
(21) Application number: 25177159.8
(22) Date of filing: 19.05.2025
(51) Int. Cl.: H10F 39/00

(54) **METHOD FOR MAKING A CHARGED-PARTICLE SENSOR THROUGH A COMBINATION OF RSD SENSORS AND THE PROCESS FOR PRODUCING MONOLITHIC CMOS SENSORS, AND CHARGED-PARTICLE SENSOR OBTAINED WITH SAID METHOD**

(30) Priority: 24.05.2024 IT 202400011773
(71) Applicant: Istituto Nazionale di Fisica Nucleare, 00044 Frascati (RM) (IT); Università Degli Studi Di Trento, 38122 Trento (IT)
(72) Inventor: PANCHERI, Lucio, 38100 Trento (IT); MANDURRINO, Marco, 00044 Frascati (IT); DA ROCHA ROLO, Manuel, 00044 Frascati (IT)
(74) Representative: Metroconsult Srl

(57) **Abstract**

Described herein is a method for making a sensor dedicated to tracking and detecting charged particles, the method comprising the following steps in succession:
- a first step of creating peripheral p-wells (31, 31', 42) suitable for hosting electronic elements (42'), and defining, by etching, trenches both in an active area (32) between said p-wells and in said peripheral p-wells (32');
- a second step of filling said trenches with silicon oxide (33, 33', 45, 45'), both in said active area (32) and in said peripheral p-wells (32');
- a third step of implanting in said active area (32) a resistive cathode (34, 43) beneath said silicon oxide (33, 45) and a multiplication layer (35, 44) beneath said resistive cathode;
- a fourth step of fabricating AC electrodes (36, 37, 41, 41') over said active area, said AC electrodes being used for capacitively coupled reading of signals generated by the passage of said charged particles,
said method providing a combination of a technology for producing RSD sensors and a process for producing monolithic CMOS sensors.

## Description

### Field of the invention

The present invention relates to the field of detection of charged particles by means of solid-state sensors, and more specifically to high-resolution tracking of charged particles in space and time.

### Background art

In the field addressed by the present invention there is a need to determine, in applications wherein particles are accelerated and made to collide, both the trajectory of the collision products and the speed at which they are generated. In particular, reference is made to high-granularity tracking of charged particles with excellent time-related performance.

It is therefore necessary to develop a layered detector, built around the interaction point, which can measure, on each layer, the position and/or the time of flight of the particles originating from the collision.

This simplified picture well represents what normally takes place in high-energy physics experiments or, with different fluxes and energies, in some application fields of medical physics such as, for example, charged-particle diagnostic imaging (proton Computed Tomography, pCT) or particle therapy, wherein tissues to be removed are bombarded with well-calibrated particle beams.

However, current technologies cannot ensure, through a single silicon sensor, a sufficient degree of precision in measuring the particles' position and time of flight to meet modem technological requirements: on the one hand, in fact, physics experiments are tending towards configurations wherein accelerators progressively increase energy and particle flux, while on the other hand diagnostic and therapy equipment needs increasingly higher precision in beam characterization and, particularly, in discriminating healthy tissues from diseased ones.

This results in the need to develop a compact and efficient detector, which can perform high-granularity tracking of charged particles with excellent time-related performance, and which can also fulfil other requirements in terms of cost optimization and impact on the quality of the extracted and processed data.

As aforesaid, the technology currently known in the art cannot meet all of the above-mentioned technological requirements. Nevertheless, some attempts have been made, with moderate success, to attain high-granularity tracking with excellent time-related performance. In this respect, the most important technology is the one known as Resistive AC-Coupled Silicon Detector (RSD). RSDs are silicon-based sensors that exploit a mechanism of internal charge amplification (Low-Gain Avalanche Diodes, LGAD), which provides high-performance signals suitable for time tracking (precision in the range of 20-30 picoseconds). In addition, unlike common space-tracking sensors, RSDs are not segmented, i.e. they are not constituted by a matrix of active elements (pixels), but their design has been studied to obtain space-tracking precision levels previously impossible to reach by silicon sensors (just a few microns of uncertainty), with homogeneous and continuous geometric efficiency throughout the sensor area (100% fill factor), which is, by definition, impossible to achieve with standard segmented (pixel-based) trackers. However, this technology can be further improved.

It is therefore necessary to develop a new technology which represents an improvement over the currently known ones.

Article by M. Mandurrino et al., "Analysis and numerical design of Resistive AC-Coupled Silicon Detectors (RSD) for 4D particle tracking", Nucl. Inst. Meth. A 959, 163479 (2020), DOI: 10.1016/j.nima.2020.163479, describes the principle of operation and computer-aided numerical design of RSD detectors.

Article by Arcidiacono et al., "High-precision 4D tracking with large pixels using thin Resistive Silicon Detectors", Nucl. Inst. Meth. A 1057, 168671 (2023), DOI: 10.1016/j.nima.2023.168671, reports the performance of RSD detectors in terms of space and time resolution in high-efficiency charged-particle tracking applications.

### Summary of the invention

It is therefore the object of the present invention to propose a technological process element, and a resulting device, which makes it possible to integrate an RSD sensor into a standard CMOS process in order to overcome all of the above-mentioned problems.

The present invention essentially concerns a novel sensor dedicated to tracking and detecting charged particles with high granularity and excellent time-related performance.

The sensor of the present invention is obtained from a combination of RSDs and the CMOS (Complementary Metal-Oxide Semiconductor) process or variants thereof, such as BiCMOS (bipolar CMOS), HV-CMOS (High-Voltage CMOS), CIS (CMOS Image Sensor).

Monolithic CMOS sensors are renowned for dominating the last decades in the field of photon detection, and their most popular commercial application concerns the camera industry.

CMOS detectors are characterized by a very compact structure, which minimizes parasitic effects in the coupling between the sensor and the reading electronics. Furthermore, due to its low cost per area unit, CMOS technology, or any one of the above-mentioned variants thereof, provides scalability as concerns the size of the fabricated structures, which makes it a commercial product that can be implemented on a large scale.

The present invention comprises a process step which is necessary and indispensable for making monolithic detectors based on the integration of an RSD sensor into CMOS technology, or any one of the above-mentioned variants thereof, which can fulfil, on the one hand, the scientific needs for high-granularity tracking with excellent time-related performance and, on the other hand, the technological needs for optimized coupling between sensor and electronics, low cost, and low material budget, i.e. reduced impact of the interaction between the particle to be detected and the silicon constituting the detector itself.

The present invention concerns a method for making, through the use of CMOS processes or variants thereof, a sensor dedicated to tracking, detecting and measuring the time of arrival of charged particles, as set out in claim 1.

The present invention further concerns a sensor dedicated to tracking, detecting and measuring the time of arrival of charged particles, as set out in claim 6.

Dependent claims 2 to 5 describe some preferred embodiments of the method.

All claims are intended as integral parts of the present description.

### Brief description of the drawings

Further objects and advantages of the present invention will become apparent in light of the following detailed description of an exemplary embodiment (and variants thereof) provided herein with reference to the annexed drawings, which are merely supplied by way of non-limiting example, wherein:
**Figure 1** shows a 2D section of the active region of an RSD sensor.
**Figure 2** shows a 2D section of a monolithic CMOS sensor with gain (CMOS LGAD).
**Figure 3** shows a simplified schematization of the process of making a monolithic CMOS RSD sensor according to the invention.
**Figure 4** shows a 2D section of the monolithic CMOS RSD sensor obtained with the method according to the invention.
**Figure 5** shows a computer-aided numerical simulation of the behaviour of a monolithic CMOS RSD sensor made in accordance with the method of the present invention.

In the drawings, the same reference numerals and letters identify the same items or components.

### Detailed description

The first technological element from which the present invention stems is an RSD silicon sensor as defined above.

As is known, the key technological elements of RSD sensors, which provide high levels of precision in simultaneous space and time measurements taken by means of a single sensor, are essentially three:
(*i*) a homogeneous and continuous (unsegmented) layer of n-doped silicon, which acts both as a charge collection electrode and as a resistive layer for suitably slowing down the charges,
(*ii*) a homogeneous and continuous layer of p-doped silicon, situated deeper than the preceding one, referred to as gain layer (or multiplication layer) and dedicated to internal charge amplification (multiplication) through the avalanche ionization mechanism, and lastly
(*iii*) a layer of dielectric (insulating) material on the entire active surface of the sensor, acting as a means through which a capacitive charge coupling is established between the n layer, i.e. the resistive one, and the metal electrodes for signal acquisition (commonly called pads, or AC-pads), deposited over the dielectric.

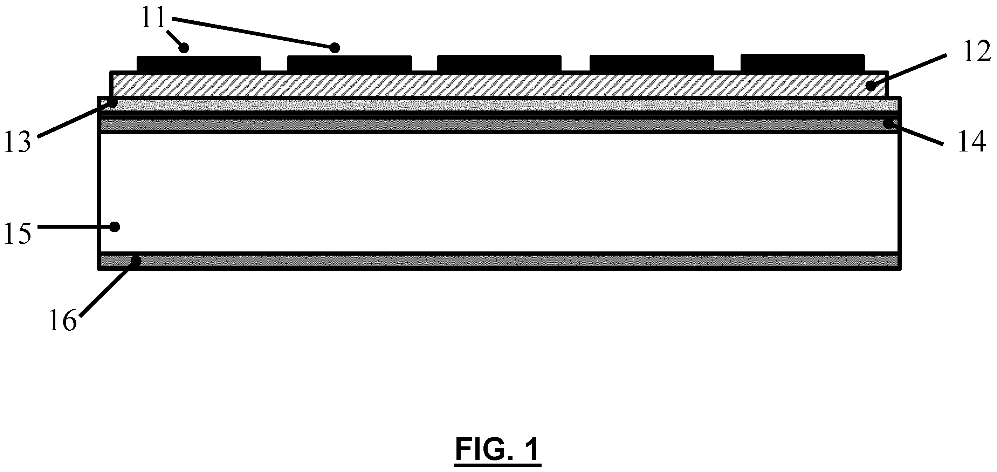

**Figure 1** shows a 2D section of the active region of an RSD sensor. One can see the metal AC-pads (11), which acquire the signals generated by the passage of the charged particles, deposited on a layer of insulating material (12), usually consisting of SiO₂ and/or silicon nitride (SiN). The n-doped resistive cathode (13) and the p-doped multiplication layer (14) (typically obtained by implanting boron ions in the first micrometres under the silicon surface) are directly implemented in silicon, and are both continuous over the entire sensor area.

The position of the track left in the sensor by the particle is reconstructed by weighing the charge contributions from the pads affected by capacitive induction, while precise time measurement is due to the multiplication layer's property of generating wide and fast signals. According to the standard technologies, the device is fabricated using a silicon substrate (15), which is usually p-doped, but LGAD technology has been proven to operate properly also in n-doped substrates. A p-doped region (16) on the side opposite the active area completes the device.

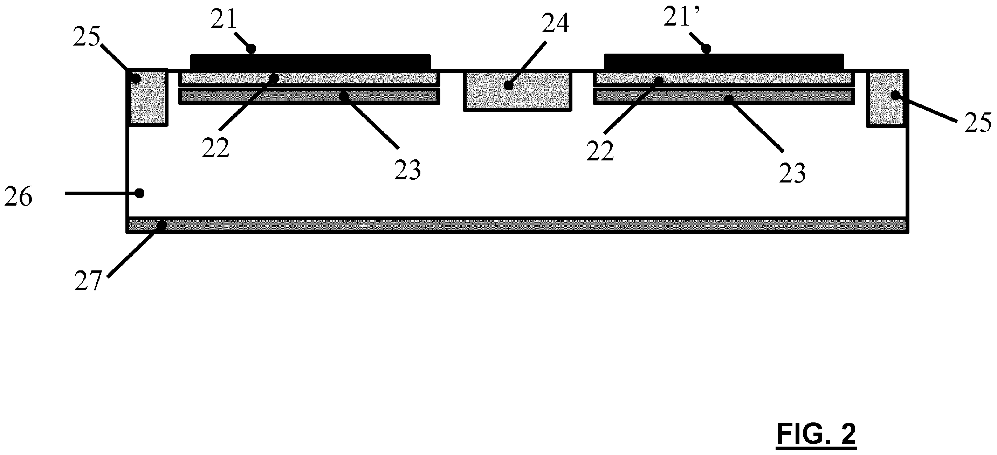

The second technological element from which the present invention stems is CMOS technology. Monolithic detectors for precise measurement of the time of flight of charged particles have recently been developed. Their basic structure is shown in Figure 2.

**Figure 2** shows a 2D section of a monolithic CMOS sensor with gain (CMOS LGAD). There are two adjacent pixels, each one composed of a metal electrode (21 and 21') for charge collection, deposited on silicon in which an n-doped cathode (22) is implanted, and, underneath, a multiplication layer (23) with typical doping levels on the order of 10¹⁷ atoms/cm³.

In the region that separates the two active regions (also referred to as pixels) there are some mutual isolation implants, schematized as a single block (24), which may be n-doped and/or p-doped regions. At the ends of both pixels there are regions (25), referred to as p-wells (p-doped silicon), which are used to isolate the electronics hosted therein from the rest of the substrate. In this type of technology, the substrate (26) is usually n-epitaxial silicon. A p-doped region (27) on the side opposite the active area completes the device.

The goal of the present invention is to combine the RSD sensor and the CMOS process, or any one of the above-mentioned variants thereof, while keeping the process flow at a standardized, unmodified level.

This means that the fundamental steps of the process for producing integrated CMOS devices remain unchanged, such as, for example:
- 1. creation of n-doped and p-doped implants (wells) that will host the transistors;
- 2. creation of protection (isolation) oxides;
- 3. definition of Gate regions by deposition of polysilicon;
- 4. creation of high-doped n+ and p+ implants that will constitute the Source and Drain regions;
- 5. creation of oxides, (horizontal) layers, and (vertical) metal vias that will constitute the interconnection layers (typically up to 10) between transistors or between transistors and sensor.

In this frame, it has been envisaged to introduce the following procedure.

During the creation of protection (isolation) oxides, referred to as Shallow Trench Isolation (STI) oxides and obtained by silicon etching followed by deposition of silicon oxide SiO₂, between the electronics' transistors (step 2 of the above-mentioned CMOS process), STIs are created also over the entire active area of the detector.

Such STIs, which may also have characteristics other than those used for the isolation function, will constitute the capacitive coupling oxide of the CMOS RSD sensor being fabricated.

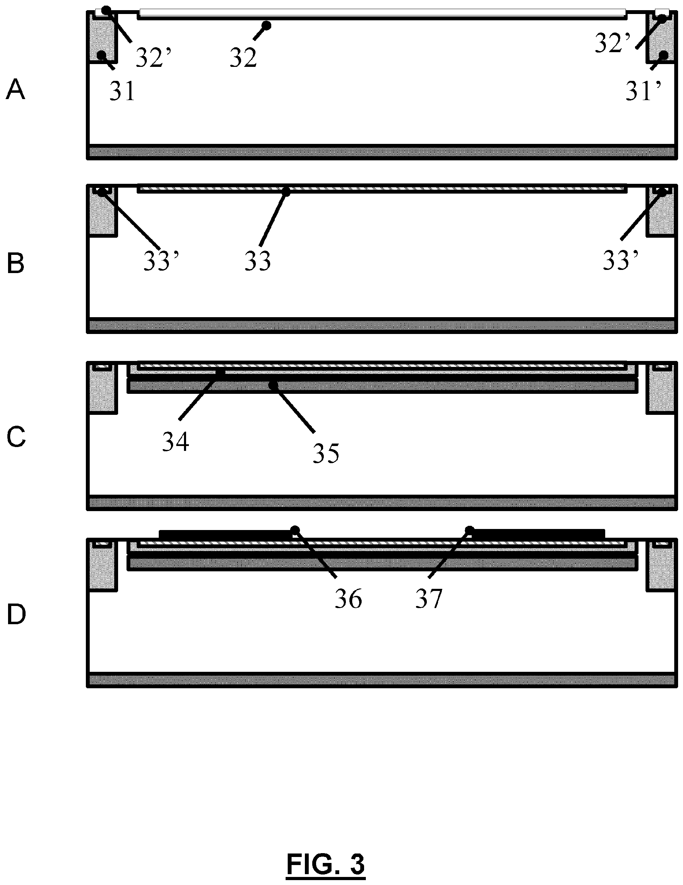

After the creation of the STIs, n (resistive cathode) and p (gain layer) layers are implanted to complete the active side of the sensor. See the steps schematized in Figure 3.

**Figure 3** shows a simplified schematization of the process of fabricating a CMOS RSD sensor with the aid of the invention of the present patent, illustrating only those process steps which are involved in the definition of the structures composing the active area of the detector.

Step A describes the creation of the p-wells that will host the electronics (31 and 31'), and the definition, by etching, of the trenches that will host the oxide (32 and 32').

In step B, the STIs are filled with silicon oxide, both in the active area (33) and in the peripheral deep p-wells (33') between the transistors (not shown). Steps A and B take place simultaneously with, respectively, steps 1. and 2. of the above-mentioned CMOS process.

Step C represents the implanting of the resistive cathode (34) and multiplication layer (35) in the active area, which occurs simultaneously with step 4.

Step D depicts the fabrication of AC electrodes - two in this example (36 and 37) - for capacitively coupled signal reading, obtained by metal deposition as envisaged in step 5. of the CMOS integration process.

The process resulting from the integration of the innovative steps described herein and those envisaged in the standard CMOS flow, or any one of the above-mentioned variants thereof, is therefore as follows:
1. creation of n-type and p-type implants (31 and 31') that will host the integrated electronics;
2. definition, by etching, of the trenches that will host the oxide (32 and 32'), both in the active area (33) and in the periphery (33');
3. filling the STI trenches with silicon oxide, acting as capacitive coupling dielectric in (33) and as protection oxide in (33');
4. definition of the Gate regions by deposition of polysilicon;
5. creation of high-doped n+ and p+ implants that will constitute the Source and Drain regions, and, in the active area, implanting the resistive cathode (34) and the multiplication layer (35);
6. creation of oxides, (horizontal) layers, and (vertical) metal vias that will constitute the interconnection layers (typically up to 10) between electronic elements or between electronic elements and sensor. In this process step, metal pads for capacitively coupled signal reading are also deposited.

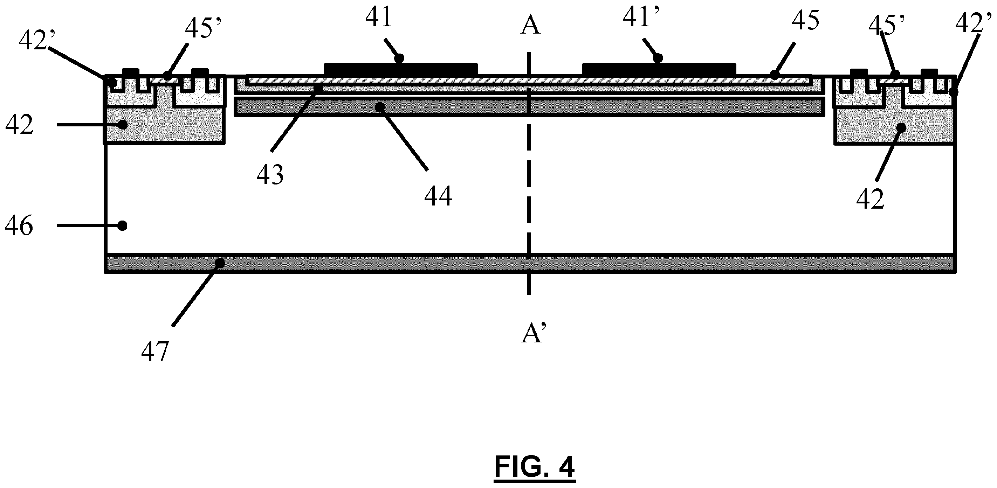

The device resulting from the process described in Figure 3, depicted by way of example in **Figure 4****,** is a monolithic CMOS RSD detector obtained from integration of an RSD sensor and reading electronics, fabricated in a CMOS process or any one of the above-mentioned variants thereof. It is, therefore, a sensor with internal multiplication suitable for taking precise measurements of the time of arrival of charged particles as well as for simultaneously tracking them in space, thanks to the mechanism that slows down the charges in the resistive cathode and to the subsequent capacitive coupling of the charges with the reading pads.

The device thus conceived and fabricated also optimizes the integration between electronics and sensor (implemented in the same silicon substrate), with advantages in terms of integration costs, adding to those inherent in a standard CMOS process, and also in terms of material budget, i.e. reduced impact of the interaction between the particle to be detected and the silicon constituting the detector itself.

By way of example, **Figure 4** shows a 2D section of the CMOS RSD sensor of the invention. In this figure one can see the metal pads (41 and 41') for capacitively coupled signal reading, the p-wells (42) hosting the transistors (42') (only sketched in the drawing), the n-doped resistive electrode (43), the p-doping multiplication layer (44), the STIs used with a dual function as a means for capacitive signal coupling in the active area of the sensor (45) and as a means for protection between the transistors at its periphery (45'), and, lastly, the substrate (46), which may be either of n-type or p-type, and the p-doped region on the back face of the detector (47).

Numerals 42' designate a non-limiting stylized example of the above-mentioned integrated electronics. In this example, it consists of two transistors (one NMOS and one PMOS) per side, whose Source and Drain regions (n+ doping in the NMOS transistor and p+ doping in the PMOS transistor) and Gate contacts (drawn with black segments between Source and Drain) are depicted.

**Figure 4** also shows a dashed vertical line between points A and A', along which the detailed list of possible materials constituting the active area of the sensor according to the invention will be defined.

Said sensor may be prevalently used in the fields of high-energy physics and medical physics, and is particularly suitable for any application requiring precise and simultaneous determination of the position and time of arrival of each particle subject to detection. It follows that its potential applications may include particle physics experiments with strict requirements in terms of high-granularity tracking with excellent time-related performance, and technological contexts wherein charged particles, e.g. protons, are used for diagnostic or therapeutic purposes. In such contexts, it is of the utmost importance to obtain very accurate and defined images of the tissues subject to medical attention, or to determine the correct dose to be set in adrotherapy beams for targeted and selective treating of specific diseases. Both of the above-mentioned medical applications also require, in addition to a precise determination of the position and time of arrival of protons, a correct energetic characterization of the same. The high-granularity tracking with excellent time-related performance provided by optimized silicon-based sensors, which can track particles and can also measure their time of flight, is the ideal solution for computing proton energy without having to resort to the apparatuses currently in use, which, the performance being the same, are certainly more expensive and bulkier.

The following will describe a sequence of possible materials resulting from the above-described process, which compose the active area of the sensor according to the present invention, listed in succession along the dashed line of Figure 4 from letter A to letter A':
- silicon dioxide SiO₂, created in steps A and B of Figure 3 (typical thickness: 100-500 nm);
- moderate-high-doped n-type silicon (n+ ~ 10¹⁵-10¹⁷ atoms/cm³), in step C;
- high-doped p++ silicon (peak concentrations p++ ~ 10¹⁷ atoms/cm³) (typical depth approx. 0.5 to 2 micrometres), described in step D;
- light-doped n-type or p-type silicon substrate (~ 10¹²-10¹⁴ atoms/cm³, thickness 10 to 50 micrometres); this specification is not dependent on the CMOS fabrication process of the invention;
- high-doped p++ contact region (~ 10¹⁷-10²⁰ atoms/cm³); this specification is not dependent on the CMOS process of the invention, but on the type of substrate in use.

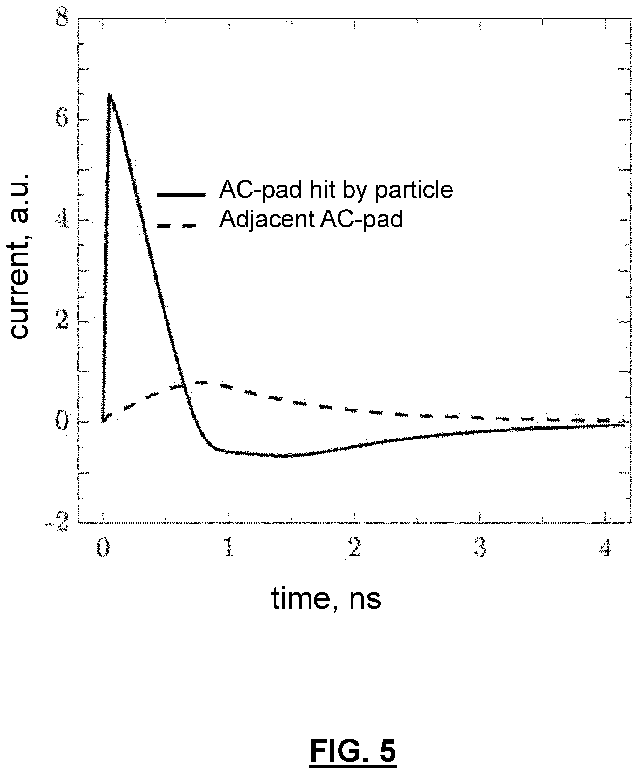

**Figure 5** illustrates a computer-aided numerical simulation of a CMOS RSD sensor fabricated in accordance with the method of the invention, showing the signals (as current expressed in arbitrary units, a.u.) obtained by having a charged particle collide with the centre of an AC-pad and by recording the time response of said pad and of its first neighbour. As far as geometry and dimensions are concerned, the CMOS RSD sensor is composed of, by way of example, square pads having a side of 60 micrometres, with a pitch of 80 micrometres. This simulation demonstrates that the novel process of the present patent results in a device capable of detecting the passage of charged particles by production of capacitive signals. Furthermore, the rise time of the signal coming from the pad hit by the particle is compatible with the requirements of a system for high-resolution time-of-arrival measurements, while the analysis of the shape and duration of the signals coming from the various pads of the sensor permits an accurate reconstruction of the position of the particle's point of impact.

In light of the above, it can be inferred that it is possible to fabricate monolithic sensors based on the reading principle of RSD sensors by means of an industrial CMOS process, whether in its standard version or in any one of the above-mentioned variants.

This can be achieved by forcing a typical element of the CMOS process, such as the so-called Shallow Trench Isolation (STI), to operate as a dielectric responsible for capacitive coupling.

The idea of exploiting STIs - the usual purpose of which is to electrically isolate contiguous regions of a CMOS circuit - as essential components for generating capacitive signals is the main feature of the present invention. At the same time, this can be considered as an "enabling technology" to achieve high-granularity tracking with excellent time-related performance, since no alternatives are currently known for bridging the technological gap between the fabrication concept of an RSD sensor and its monolithic embodiment in CMOS technology or in any one of the above-mentioned variants thereof, clearly resulting in an advantageous industrial impact in terms of economical competitiveness and production volume.

It can also be added that a technological element of the process of fabrication of integrated CMOS devices is introduced which is based on the internal multiplication mechanism (LGAD) and the RSD reading system, and which allows creating an innovative monolithic sensor for high-granularity tracking of charged particles with excellent time-related performance.

Said technological element envisages the fabrication of oxide dedicated to generating the capacitive coupling of the signals, which is typical of the RSD paradigm, by creating Shallow Trench Isolation (STI) oxides, commonly used for electrical protection between adjacent transistors, also in the active area of the sensor. Such STIs constitute, therefore, the dielectric through which the charges multiplied in silicon induce a capacitive signal on the metal pads.

The device of the invention, which results from the introduction of STIs performing the above-described function in the process flow, is technically a monolithic RSD, i.e. a particle detector combining the advantages of an integrated monolithic CMOS sensor (low cost per area unit, optimized coupling between sensor and electronics, low material budget) with those offered by RSD sensors (100% fill factor, high space and time resolutions).

The above-described process steps A-D, executed in this order at that specific point of the fabrication flow and applied to the specified regions of the sensor, constitute, as a whole, the subject of the invention.

The other steps of the overall process are per se known, since they are parts of the CMOS fabrication process. They will not therefore be described herein, in that a person skilled in the art will be perfectly able to implement them.

The above-described example of embodiment may be subject to variations without departing from the protection scope of the present invention, including all equivalent designs known to a person skilled in the art.

In light of the above description, those skilled in the art will be able to produce the subject of the invention without introducing any further construction details.

## Claims

1. Method for making a sensor dedicated to tracking and detecting charged particles, the method comprising the following steps in succession:
- a first step of creating peripheral p-wells (31, 31', 42) suitable for hosting electronic elements (42'), and defining, by etching, trenches both in an active area (32) between said p-wells and in said peripheral p-wells (32');
- a second step of filling said trenches with silicon oxide (33, 33', 45, 45'), both in said active area (32) and in said peripheral p-wells (32');
- a third step of implanting in said active area (32) a resistive cathode (34, 43) beneath said silicon oxide (33, 45) and a multiplication layer (35, 44) beneath said resistive cathode;
- a fourth step of fabricating AC electrodes (36, 37, 41, 41') over said active area, said AC electrodes being used for capacitively coupled reading of signals generated by the passage of said charged particles,
said method providing a combination of a technology for producing RSD sensors and a process for producing monolithic CMOS sensors or CMOS variants.

2. Method according to claim 1, wherein one or more of the following materials are used for composing said active area:
• silicon dioxide SiO₂, in said first and second steps,
• moderate-high-doped n-type silicon (n+ ~ 10¹⁵-10¹⁷ atoms/cm³), in said third step,
• high-doped p++ silicon (peak concentrations p++ ~ 10¹⁷ atoms/cm³), in said fourth step.

3. Method according to claim 2, wherein:
- said silicon dioxide having a thickness of 100-500 nm;
- said high-doped p++ silicon having a depth of 0.5 to 2 micrometres.

4. Method according to any one of the preceding claims, comprising the following additional steps:
• fabricating a light-doped n or p silicon substrate (~ 10¹²-10¹⁴ atoms/cm³),
• fabricating a high-doped p++ contact region (~ 10¹⁷-10²⁰ atoms/cm³).

5. Method according to claim 4, wherein said silicon substrate having a thickness between 10 and 50 micrometres.

6. Sensor dedicated to tracking and detecting charged particles, said sensor being obtained by means of the method according to any one of the preceding claims and comprising:
- silicon oxide (33, 33', 45, 45') in said trenches, both in said active area (32) and in said peripheral p-wells (32');
- a resistive cathode (34, 43) in said active area (33), beneath said silicon oxide (33, 45);
- a multiplication layer (35, 44) in said active area (33), beneath said resistive cathode;
- one or more AC electrodes (36, 37, 41, 41') over said active area.
